Europäisches Patentamt

European Patent Office

Office européen des brevets

(11) Publication number: **0 573 002 A1**

# EUROPEAN PATENT APPLICATION

(21) Application number: **93108858.7**

(22) Date of filing: **02.06.93**

(51) Int. Cl.⁵: **C23C 14/34**, C22C 21/02, H01L 23/485

(30) Priority: **03.06.92 JP 166696/92**
**20.10.92 JP 306199/92**

(43) Date of publication of application:
**08.12.93 Bulletin 93/49**

(84) Designated Contracting States:
**DE FR GB**

(71) Applicant: **MITSUBISHI KASEI CORPORATION**
**5-2, Marunouchi 2-chome**
**Chiyoda-ku**
**Tokyo 100(JP)**

(72) Inventor: **Ueda, Tadao**
**4-10-5-206, Inokata**
**Komae-shi, Tokyo(JP)**

(74) Representative: **Hansen, Bernd, Dr.**
**Dipl.-Chem. et al**
**Hoffmann, Eitle & Partner**
**Patent- und Rechtsanwälte,**
**Postfach 81 04 20**
**D-81904 München (DE)**

(54) **Sputtering target, wiring method for electronic devices and electronic device.**

(57) Disclosed herein is a sputtering target comprising an aluminum alloy consisting essentially of 0.01 to 3 wt% of Si and the balance aluminum or consisting essentially of 0.01 to 3 wt% of Si, 0.01 to 3 wt% of at least one element selected from the group consisting of Cu, Ti, Pd, Zr, Hf and rare earth elements, and the balance aluminum, a maximum particle diameter of precipitated particles of a solute element or solute elements in the aluminum alloy being not more than 0.1 mm and a solid solution ratio in the aluminum alloy being more than 30%.

EP 0 573 002 A1

## BACKGROUND OF THE INVENTION

The present invention relates to a sputtering target, a wiring method for electronic devices, and an electronic divice.

The wiring layers for electronic devices such as LSI and a magnetic head have been produced by forming a thin film of about 1 $\mu$m in thickness, mainly composed of aluminum, on an insulating layer and forming a desired pattern of the thin film by lithography. Sputtering is popularly employed for forming the thin films. This technique has the advantage especially in that the control of the composition of the wiring layer can be made accurately, because the composition of the thin wiring layer formed from the target agrees very closely with the composition of the sputtering target material.

As the sputtering target material, there are used the aluminum alloys to which a small quantity of an element or elements is added for improving the mechanical and other properties of the wiring layers mainly composed of aluminum. Usually, aluminum alloys containing 0.01 to 3 wt% of Si, or 0.01 to 3 wt% of Si and 0.01 to 3 wt% of at least one element selected from the group consisting of Cu, Ti, Pd, Zr, Hf and rare earth elements are used.

It is known that in the recent microstructurized LSI's and other electronic devices, solute elements such as Si, etc. of the aluminum alloys are precipitated in the form of particles in the wiring layer thereof. The precipitated particles may combine with each other to form agglomerates of about 1 $\mu$m in diameter. Such particle agglomerates might block a path of current or short-circuit the paths depending on the solute element, and in some cases could cause serious troubles such as disconnection or break of wiring pattern or short circuit of wiring pattern, especially when the wiring pattern is of a small width on the order of 1 $\mu$m, such as employed for the microstructurized LSI's. Thus, precipitation of the particles has been a detrimental factor to reliability of LSI and other electronic devices.

In an effort to solve the above-mentioned problem of precipitated particles in the wiring patterns for the electronic devices such as LSI, the present inventors have made extensive studies on the methods for reducing a size of precipitated particles in the aluminum alloy as the wiring pattern and, as a result, found that by controlling a ratio of the solute element(s) existing as a solid solution in the aluminum alloy as the sputtering target and reducing the size of the precipitated particles of the solute element(s) in the aluminum alloy as the sputtering target, the the particles precipitated in the alloy which consitutes the wiring pattern are finely divided and uniformly dispersed. The present invention has been achieved on the basis of this finding.

## SUMMARY OF THE INVENTION

An object of the present invention is to provide a sputtering target improved to prevent trouble of wiring pattern caused by blockage of current path in the wiring pattern or short circuit of the current paths with the precipitated particles of the solute element(s) in the aluminum alloy constituting the wiring pattern, thereby enabling manufacture of the electronic devices with high reliability. It is also provided in the present invention a wiring method for electronic devices with high reliability by using the sputtering target.

In a first aspect of the present invention, there is provided a sputtering target comprising an aluminum alloy consisting essentially of 0.01 to 3 wt% of Si and the balance aluminum, or consisting essentially of 0.01 to 3 wt% of Si, 0.01 to 3 wt% of at least one element selected from the group consisting of Cu, Ti, Pd, Zr, Hf and rare earth elements, and the balance aluminum, a maximum particle diameter of precipitated particles of a solute element or solute elements in the aluminum alloy being not more than 0.1 mm and a solid solution ratio in the aluminum alloy being more than 30%.

In a second aspect of the present invention, there is provided a method of producing a wiring layer for an electronic device, which comprises forming a thin film of an aluminum alloy at a wafer temperature of not higher than 300°C by using a sputtering target as defined in the first aspect; and subjecting the formed thin film to lithography.

In a third aspect of the present invention, there is provided an electronic device having a wiring layer comprising an aluminum alloy containing precipitated particles of a solute element or solute elements having not more than 0.7 $\mu$m in maximum particle diameter.

## DETAILED DESCRIPTION OF THE INVENTION

In the sputtering target according to the present invention, the solid solution ratio in the aluminum alloy which consitutes the sputtering target is more than 30%, preferably 40 to 95%, more preferably 50 to 90%. In the present invention, the solid solution ratio (S) is defined as follows:

$$S = ((C1 - C3)/(C1 - C2)) \times 100\%$$

wherein C1 is an electric conductance of high-purity aluminum (having a purity of not less than 99.999%), C2 is an electric conductance of the aluminum alloy obtained by rapidly cooling (within 60 seconds) in water of room temperature from a high temperature (550°C), and C3 is an electric conductance of the aluminum alloy of the test target.

In the present invention, the term "rare earth elements" means Y, Sc and lanthanoids.

In view of the fact that the composition of the wiring pattern and the state of solid solution therein agrees precisely with those of the target material, it seems that by increasing the solid solution ratio in the aluminum alloy which constitutes the target and making a size of precipitated particles of the solute element(s) in the aluminum alloy as the sputtering target small, it is possible to prevent precipitation of the particles having such a large size, for example, not less than 1$\mu$m in the wiring pattern so as to block or short-circuit the current paths in the wiring pattern, thereby improving reliability of the wiring of the electronic devices.

The sputtering target of the present invention can be obtained by a specific heat treatment of the aluminum alloy. For instance, an aluminum alloy obtained by a semi-continuous casting method or other means is once heated (first heat-treatment) at a temperature of 500 to 650°C, which is the temperature region where the liquid phase and the solid phase coexist, for a period of 30 minutes or more, whereby the element(s) previously precipitated during cooling after casting is(are) again brought into the state of solid solution in a matrix (aluminum); and the resultant aluminum alloy is rapidly cooled, whereby an aluminum alloy with the solid solution ratio (S) of not less than 95% is obtained; and the resultant aluminum alloy is subject to molding such as compression processing for sputtering target.

Since the above-mentioned rapidly cooled aluminum alloy generally has a large grain size of 10 to 50 mm, the the rapidly cooled aluminum alloy is not suited as a material for a sputtering target. Also, the aluminum alloy obtained by a compression processing for producing a target has distorted grains which are not desirable for a sputtering target.

Therefore, the obtained aluminum alloy is again heated (second heat-treatment) at a temperature between 100°C and 500°C, preferably 200 to 500°C, more preferably 200 to 400°C for from not less than 5 minutes to less than 30 minutes, preferably 10 to 20 minutes. By this second heat-treatment, while a part of the solute element(s) brought into the state of solid solution is precipitated, more than 30% of such solute element(s) is left in the solid solution.

The temperature of the second heat-treatment depends on the purity of aluminum as a raw material, the composition of the aluminum alloy, especially, the content of Si in the aluminum alloy, and the temperature of the first heat-treatment. For example, in the case where the content of Si in the aluminum alloy is lower, the second heat-treatment can be carried out at lower temperature, thereby obtaining the sputtering target of the present invention. Accordingly, in conformity with the aluminum purity, the composition of the aluminum alloy, especially, the Si content therein and the temperature of the first heat-treatment, it is possible to select the temperature of the second heat-treatment in the range of 100 to 500°C so as to produce the sputtering target having more than 30% of the solid solution ratio in the aluminum alloy and not more than 0.1 mm of the maximum particle diameter of the precipitated particles of the solute element(s) in the aluminum alloy.

It is thus possible to realize simultaneously a high solid solution ratio of more than 30%, preferably 40 to 95%, more preferably 50 to 90% in an aluminum alloy and to reduce size of the precipitated particles of the solute element(s) in the aluminum alloy as the sputtering target to, for example, not more than 0.1 mm, preferably not more than 0.05 mm in a maximum particle diameter.

If the maximum particle diameter is larger than 0.1 mm, when carrying out the sputtering processing, an electrical field on around sputtering surface of the sputtering target is locally disarranged by a large particle and a discharging current is focused on around such large particle, thereby causing abnormal discharge. In the case of generating the abnormal discharge, the target material is scattered from the sputtering surface to a substrate in a cluster form and by the scattered nuclear cluster, particles are formed in the thin film.

The grain size (diameter) of the aluminum alloy as the sputtering target is usually 0.1 to 1 mm, preferably 0.1 to 0.6 mm, more preferably 0.1 to 0.3 mm as measured by JIS H0501.

The sputtering target of the present invention is preferably produced in the following way. First, conventionally, 0.01 to 3 wt% of Si based on the aluminum alloy is added, or 0.01 to 3 wt% of Si based on the aluminum alloy and 0.01 to 3 wt% of at least one element selected from Cu, Ti, Pd, Zr, Hf and rare earth elements based on the aluminum alloy are added to a high-purity aluminum (usually with a purity of 99.99% or higher). They are melted and mixed and cast into a round bar of about 100 to 200 mm in diameter and about 1 to 5 m in length by a semi-continuous casting method. Diameter and length of the bar can be optionally selected.

In the semi-continuous casting method, solidification of the product is accomplished at a relatively high solidification rate through the cooling step. Despite of such a high solidification rate, however, there takes place precipitation or partial segregation of the solute element(s) in the course of casting. In order to bring the precipitated and/or segregated solute element(s) into the state of solid solution, the aluminum alloy obtained by the said semi-continuous casting is heated at 500 to 650°C for 30 minutes or more (first heat-treatment), whereby the precipitated and/or segregated solute element(s) is(are) again dissolved in the aluminum solvent. From this temperature condition, the aluminum alloy is rapidly cooled to room temperature or below within a period of 10 minutes, preferably within one minute, by a suitable means such as dipping in water or water spraying. By this first heat-treatment, the aluminum alloy is allowed to maintain the same state of solid solution at high temperature even after the alloy has been cooled down to room temperature, and consequently, a round bar alloy with a solid solution ratio of not less than about 95% and a grain size of about 30 mm is usually obtained.

The obtained round bar is subjected to a compression processing such as rolling or forging to form a target. The formed product is again heated at a temperature of 100 to 500°C for not less than 5 minutes to less than 30 minutes (second heat-treatment) so as to adjust the solid solution ratio at more than 30%, preferably 40 to 95%, more preferably 50 to 90%, to reduce a size of the precipitated particles of the solute element(s) to not more than 0.1 mm, preferably not more than 0.05 mm in a maximum particle diameter and to disperse uniformly the precipitated particles in the aluminum alloy as the sputtering target.

By using the aluminum alloy sputtering target of the present invention, a thin aluminum alloy film is formed by a conventional method such as magnetron sputtering. Usually, an Ar pressure in sputtering is 2 to 8 mTorr, and the wafer temperature is not higher than 300°C, preferably 60 to 300°C.

A maximum particle diameter of precipitated particles in the thin film of the aluminum alloy is not more than 0.7 $\mu$m, preferably not more than 0.5 $\mu$m. An average number of particles in an area of 10 $\mu$m $\times$ 10 $\mu$m is preferably not more than 12.

The thus formed aluminum alloy film is subjected to a heat treatment usually at 300 to 450°C for 5 to 60 minutes, preferably about 30 minutes, and then a wiring pattern is formed thereon by lithography. Known techniques can be employed for the lithography in the present invention.

Thus, an electronic device having a wiring layer having a wiring layer comprising an aluminum alloy containing precipitated particles of a solute element or solute elements having not more than 0.7 $\mu$m in maximum particle diameter is obtained.

EXAMPLES

As described below, the aluminum alloy sputtering targets were produced according to the present invention and by using each of the targets, a thin film was formed on a Si wafer by sputtering. These thin films and those similarly formed by using sputtering targets of comparative examples were compared by way of the solid solution ratio, a disconnection ratio, a maximum particle diameter in the thin film, a maximum particle diameter in the sputtering target, a number of abnormal discharge, an average number of particles and a grain size which were determined by the following methods.

(1) Solid solution ratio

The solid solution ratio is determined from the following calculation based on the measurements of electric conductance:

$$S = ((C1 - C3)/(C1 - C2)) \times 100\%$$

wherein C1 is an electric conductance of a high-purity aluminum (having a purity of not less than 99.999%), C2 is an electric conductance of an aluminum alloy obtained by rapidly cooling (within 60 seconds) in water of a room temperature from a high-temperature state (550°C), and C3 is an electric conductance of an aluminum alloy wihch constitutes a test target.

(2) Disconnection ratio

From each of the thin film layers formed by using the respective test targets, ten fine lines of 2 $\mu$m in width and 2 mm in length are formed as a pattern by lithography. An electric current is passed through each of said fine lines under the specific conditions (current density: 4 x $10^6$ A/cm$^2$; current application time: 200 hr; wafer temperature: 200°C), and the ratio of the number of the fine lines broken or disconnected in passing the electric current to the total number of the fine lines is defined as the disconnection rate.

(3) Maximum particle diameter in the thin film

A wafer having a thin film formed thereon is heated to 450°C and, after kept in this state for 30 minutes, etched in aqua regia (HNO$_3$:HCl = 1:3) of 10 to 60°C for 10 seconds to 30 minutes, and the aluminum which constitutes the solvent portion of the aluminum alloy is dissolved. By this operation, the particles precipitated in the alloy are left, and these particles are observed under a scanning electron microscope (SEM) to determine the maximum particle diameter of the precipitated particles in an area of 10 $\mu$m $\times$ 10 $\mu$m.

(4) Maximum particle diameter

A surface of a sputtering target is abraded by an abrasive-coated paper (#1000) and then buffed. The buffed surface is treated by Keller etching solution to allow the precipitates to be raised. The treated surface is observed by a metallofraphic microscope. Magentifying power is 1,000. The maximum particle diameter is defined as a diameter of the largest particle within a field of view of 4 cm $\times$ 5 cm which is a part of the sputtering surface of the target.

(5) Number of abnormal discharge

Abnormal dischage is detected by detecting a peak of discharging current. The number is counted for 10 minutes.

(6) Average number of particles

A number of particles in a thin film formed on a wafer is measured by laser particle counter LS5000 (manufactured by Hitachi Co., Ltd.) as to particles of not less than about 1 $\mu$m which is limit of detection thereof, with respect to a whole surface of a wafer having a diameter of 6 cm. The number of particles is measured as to 10 wafers and an average is calculated.

(7) Grain size

A grain size of the aluminum alloy as the sputtering target is measured by JIS H0501.

Examples 1-5

An Al-1 wt% Si-0.5 wt% Cu alloy, which is most popularly employed for LSI, etc., at present, was used as the aluminum alloy for the targets. As the sample targets for evaluation, there were produced the targets of Examples 1 and 5. Each target measured 250 mm in diameter and 15 mm in thickness.

Each sample target was produced under the heat treatment and cooling conditions shown in Table 1.

Table 1

| Target Samples | Example 1 | Example 2 | Example 3 | Example 4 | Example 5 |
|---|---|---|---|---|---|
| First heat treatment | 540°C, 12 hours | | | 550°C, 12 hours | |
| Cooling | Cooled in water to room temperature in about one minute. | | | | |
| Second heat treatment | 400°C, 15 min. | 480°C, 15 min. | 500°C 15 min. | 350°C 15 min | 250°C 15 min |

A sputtering device MLX 300 (mfd. by Nippon Vacuum Technology Co., Ltd.) was used for sputtering of each sample target. Sputtering was carried out under the following conditions: Ar pressure: 4 mTorr; sputtering power: 6.5 kW; wafer temperature: 200°C. An SiO$_2$ film was formed on the surface of the wafer before forming a thin film thereon. On the surface of the SiO$_2$ film, a thin film was formed by sputtering of each of the sample targets of the above Examples to obtain a thin film wiring layer having a thickness of 0.8 μm.

The thus obtained sample targets and wiring layers were subjected to evaluation in terms of the solid solution ratio, the disconnection ratio, the maximum particle diameter in the thin film, the maximum particle diameter in the sputtering target, the number of abnormal discharge, the average number of particle in thin film and the grain size of the aluminum alloy as the sputtering target.

Table 2

| Target Samples | Example 1 | Example 2 | Example 3 | Example 4 | Example 5 |
|---|---|---|---|---|---|
| Solid solution ratio in the sputtering target (%) | 40 | 70 | 90 | 35 | 50 |
| Disconnection ratio (%) | 0 | 0 | 0 | 0 | 0 |
| Maximum particle diameter in the thin film (μm) | 0.5 | 0.3 | 0.3 | 0.5 | 0.4 |
| Maximum particle diameter in the sputtering target (mm) | 0.06 | 0.08 | 0.07 | 0.05 | 0.01 |
| Number of abnormal discharge (/10 min) | 20 | 26 | 20 | 15 | 5 |
| Average number of particles in thin film | 10 | 11 | 9 | 7 | 3 |
| Grain size in the sputtering target (mm) | 0.3 | 0.4 | 0.5 | 0.4 | 0.5 |

As seen from Table 2, in the wiring patterns obtained from the targets of Examples 1 to 5 in which the solid solution ratio of more than 30%, the maximum particle diameter of precipitated particles was less than 0.1 mm, there occurred no disconnection by passage of the current and low frequent emergence of abnormal discharge. Thus, by adjusting the solid solution ratio in the aluminum alloy composing the target so as to be higher than 30% and the maximum particle diameter of the precipitated particles so as to not more than 0.1 mm, the reliability of the wiring pattern formed by sputtering of an aluminum alloy target is enhanced.

## Claims

1. A sputtering target comprising an aluminum alloy consisting essentially of 0.01 to 3 wt% of Si and the balance aluminum, or consisting essentially of 0.01 to 3 wt% of Si, 0.01 to 3 wt% of at least one element selected from the group consisting of Cu, Ti, Pd, Zr, Hf and rare earth elements, and the balance aluminum, a maximum particle diameter of precipitated particles of a solute element or solute elements in the aluminum alloy being not more than 0.1 mm and a solid solution ratio in said aluminum alloy being more than 30%.

2. A sputtering target according to claim 1, wherein a maximum particle diameter of precipitated particles in the aluminum alloy is not more than 0.05 mm.

3. A sputtering target according to claim 1, wherein a grain size of said aluminum alloy is 0.1 to 1 mm.

4. A method of producing a wiring layer for an electronic device, which comprises forming a thin film of an aluminum alloy at a wafer temperature of not higher than 300°C by using a sputtering target as defined in claim 1; and subjecting the formed thin film to lithography.

5. A method according to claim 4, wherein a maximum particle diameter of the precipitated particles of the solute element or the solute elements in the aluminum alloy of the thin film is not more than 0.7 μm.

6. An electronic device having a wiring layer comprising an aluminum alloy containing precipitated particles of a solute element or solute elements having not more than 0.7 μm in maximum particle diameter.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X<br>A | EP-A-0 361 572 (PHILIPS)<br>* column 1, line 49 - column 2, line 4; figures 1-6 * | 6<br>4,5 | C23C14/34<br>C22C21/02<br>H01L23/485 |
| X | US-A-4 999 160 (LOWREY ET AL.)<br>* column 4, line 6 - line 28; figures 7,8 * | 6 | |
| A | EP-A-0 466 617 (ALUMINIUM PECHINEY)<br>* claims 1-6 * | 1-3 | |

TECHNICAL FIELDS SEARCHED (Int. Cl.5)

C23C

The present search report has been drawn up for all claims

| Place of search | Date of completion of the search | Examiner |
|---|---|---|
| THE HAGUE | 10 SEPTEMBER 1993 | PATTERSON A.M. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)